# EUROPEAN PATENT APPLICATION

(11) **EP 4 718 713 A1**
(43) Date of publication of application: **01.04.2026**
(21) Application number: 25204300.5
(22) Date of filing: 24.09.2025
(51) Int. Cl.: H03F 1/02, H03F 1/56

(54) **DOHERTY POWER AMPLIFIER WITH HARMONIC FREQUENCY RESONANCE CIRCUIT COUPLED TO A RECONFIGURABLE IMPEDANCE INVERTER CIRCUIT**

(30) Priority: 25.09.2024 US 202418895441
(71) Applicant: NXP USA, Inc., Austin, TX 78735 (US)
(72) Inventor: WEI, Yun, 5656AG Eindhoven (NL); WANG, Lu, 5656AG Eindhoven (NL)
(74) Representative: Hardingham, Christopher Mark

(57) **Abstract**

A Doherty power amplifier includes a combining node that combines amplified output signals from first and second amplifiers. A reconfigurable impedance inverter circuit is coupled between the first amplifier and the combining node. The impedance inverter circuit includes an inductive element coupled between a first node and a second node, and a switching circuit coupled between the first node and the second node. A fundamental frequency tuning circuit and a harmonic frequency resonance circuit are coupled between the switching circuit and a ground reference node. When the switching circuit is configured in a first state, the fundamental frequency tuning circuit and the harmonic frequency resonance circuit are electrically coupled through the switching circuit to the first and second nodes. When the switching circuit is configured in a second state, the fundamental frequency tuning circuit and the harmonic frequency resonance circuit are electrically disconnected from the first and second nodes.

## Description

### TECHNICAL FIELD

Embodiments of the subject matter described herein generally relate to Doherty power amplifiers.

### BACKGROUND

For many years, the Doherty power amplifier has been one of the most popular amplifiers for cellular infrastructure applications, given its ability to provide efficient and linear amplification of high peak-to-average power ratio (PAPR) signals. A well-designed, conventional Doherty power amplifier exhibits linear signal amplification across a range of average output power levels, with high efficiency amplification being achievable in the high power region of operation. Further, in comparison with balanced amplifiers, a Doherty power amplifier may exhibit better efficiency when the output power is backed off from saturation.

To achieve high-efficiency operation, attempts are made to design Doherty power amplifiers so that power dissipated within the amplifier is minimized. A well-designed Doherty power amplifier is configured to most efficiently amplify radio frequency (RF) signals that have their signal energy centered around a particular fundamental frequency of operation. Due to nonlinearities and impedance mismatches within the amplifier, however, signal energy at harmonic frequencies (e.g., second and higher order harmonic frequencies) may be added into an RF signal being that is being amplified by a Doherty power amplifier. The presence of the harmonic signal energy may degrade the efficiency and linearity of the Doherty power amplifier. Therefore, some Doherty power amplifier designs include harmonic termination circuits at the inputs and/or outputs of the carrier and peaking amplifiers.

A challenge that persists is that, in some types of Doherty power amplifiers, harmonic termination circuitry at the input and/or output of the carrier and peaking amplifiers may undesirably limit the bandwidth of the amplifier. Specifically, the dispersive nature of the backed-off power load impedance (Zmod) at the fundamental frequency of operation for some Doherty power amplifiers (e.g., 90/0 Doherty power amplifiers) may discourage the inclusion of conventional harmonic frequency resonance circuits in such amplifiers. However, the absence of harmonic termination circuitry limits performance of a Doherty power amplifier. Accordingly, what are needed are Doherty power amplifier designs that provide good harmonic frequency terminations without unduly limiting the bandwidth of the amplifier.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a simplified block diagram of an example communication apparatus in which an embodiment of a Doherty power amplifier may be incorporated;
FIG. 2 is a graph illustrating theoretical efficiency performance as a function of full and reduced output power levels for an embodiment of a Doherty power amplifier;
FIG. 3 is a schematic drawing of a Doherty power amplifier in a full-power state, where the Doherty power amplifier includes a harmonic frequency resonance circuit and a fundamental frequency tuning circuit electrically coupled to a reconfigurable impedance inverter circuit, in accordance with an example embodiment;
FIG. 4 is a schematic drawing of the Doherty power amplifier of FIG. 3 in a reduced-power state in which the harmonic frequency resonance circuit and the fundamental frequency tuning circuit are electrically disconnected from the reconfigurable impedance inverter circuit, in accordance with an example embodiment;
FIG. 5 is a schematic drawing of a reconfigurable impedance inverter circuit, in accordance with another example embodiment;
FIG. 6 is a schematic drawing of a reconfigurable impedance inverter circuit, in accordance with yet another example embodiment; and
FIG. 7 is a flowchart of a method of operating a Doherty power amplifier, in accordance with an example embodiment.

### DETAILED DESCRIPTION

A conventional Doherty amplifier includes, among other things, an amplifier input terminal for receiving a radio frequency (RF) signal, a power splitter, a carrier amplifier, a peaking amplifier, an output circuit, and an amplifier output terminal. The output circuit includes a combining node, which is coupled to the outputs of both the carrier and peaking amplifiers, and which corresponds to the circuit node at which the amplified carrier and peaking signals are combined. The output of the carrier amplifier is coupled to the combining node through a fixed impedance inverter. The combining node is coupled to the amplifier output terminal through an output transformer.

According to one or more embodiments, the combining node is coupled to the output of the carrier amplifier through a reconfigurable impedance inversion and phase shift circuit (referred to also herein as a "reconfigurable impedance inverter circuit" or a "tunable quasi-line"). A first inductor-capacitor (LC) network configured to resonate at or near the second harmonic frequency (*2f₀*) is attached to the reconfigurable impedance inverter circuit. In addition, a second LC network that is tuned for impedances at the fundamental frequency of operation (*f₀*) also is attached to the reconfigurable impedance inverter circuit. The values of the inductive elements and capacitors of the first and second LC networks and the positions of the first and second LC networks along the reconfigurable impedance inverter circuit may be carefully selected to optimize the impedances at both 2*f₀* and *f₀*. With this approach, the efficiency of the Doherty power amplifier embodiments may be improved significantly, while maintaining the same bandwidth. Furthermore, as described in detail below, the proposed reconfigurable impedance inverter circuit can be combined with various other reconfigurable circuits to provide for efficiency enhancements based on traffic loading conditions (e.g., traffic tracking).

As will be discussed in detail below, embodiments of the reconfigurable impedance inverter circuit include a series of phase shift elements (e.g., a series of transmission line segments) that are configured to provide an impedance inversion and to impart a phase delay to an amplified RF signal that is conveyed between the output of the carrier amplifier and the combining node. Further embodiments of the reconfigurable impedance inverter circuit include a fundamental frequency tuning circuit and harmonic frequency resonance circuit, both of which are coupled through a switching circuit to the reconfigurable impedance inverter circuit. The fundamental frequency tuning circuit is configured to optimize impedances at the fundamental frequency of operation of the Doherty power amplifier, and is configured to resonate at or near the fundamental frequency (e.g., where "at or near" means at precisely the fundamental frequency, *f₀*, or at a frequency between about 90 percent and about 110 percent of *f*₀)*.* The harmonic frequency resonance circuit is configured to resonate at or near the second harmonic frequency (e.g., where "at or near" means at precisely the second harmonic frequency, 2*f*₀, or at a frequency between about 90 percent and about 110 percent of 2*f₀*). Accordingly, during operation of the Doherty power amplifier, the harmonic frequency resonance circuit functions to remove signal energy at or near the second harmonic frequency from the amplified carrier signal.

Further embodiments of Doherty power amplifiers include additional tuning circuits, which are coupled to the output transformer and to the output terminals (e.g., intrinsic drain terminals) of the carrier and peaking amplifiers. These additional tuning circuits also are reconfigurable, which enables the correct and proper impedances to be established at the carrier and peaking output terminals for multiple average output power levels, thus enabling high-efficiency signal amplification to be achievable at full average output power levels and at reduced average output power levels.

As used herein, the reconfigurable impedance inverter circuit (including the harmonic frequency resonance circuit and the fundamental frequency tuning circuit) and the "additional tuning circuits" may be collectively referred to as "reconfigurable output circuits." Further, by virtue of the Doherty power amplifiers described herein having "reconfigurable output circuits," such Doherty power amplifier embodiments may be referred to herein as "reconfigurable Doherty power amplifiers."

As used herein, the term "reconfigurable," in the context of a circuit, means that the states (e.g., electrical characteristics, electrical connections, electrical states, and/or values) of components, nodes and/or sub-circuits within the reconfigurable circuit may be selectively changed during operation. According to one or more embodiments, the reconfigurable output circuits may be selectively configured into any of a plurality of different states. Two specific states (specifically a "full-power state" and a "reduced-power state") are discussed in detail herein. Those of skill in the art would understand, based on the description herein, that the embodiments of reconfigurable output circuits discussed herein could be configured into other states, as well.

As will be described in detail later, embodiments of reconfigurable Doherty power amplifiers described herein are capable of being dynamically reconfigured into different amplifier states. For example, in some embodiments, a reconfigurable Doherty power amplifier may be electronically controlled into different amplifier states based on the actual or anticipated traffic loading (e.g., based on how many users are or are anticipated to be communicating on the system). For example, when the communication apparatus that includes the reconfigurable Doherty power amplifier is (or is anticipated to be) processing high levels of traffic (e.g., between 75% and 100% traffic loading), the system may determine that the reconfigurable Doherty power amplifier should be configured (or reconfigured) into a "full-power state" in which the amplifier should operate efficiently at full average output power levels. Conversely, when the amplifier system is (or is anticipated to be) processing lower levels of traffic (e.g., below 75% traffic loading), the system may determine that the reconfigurable Doherty power amplifier should be configured (or reconfigured) into a "reduced-power state" in which the amplifier should operate efficiently at a reduced average output power level. Either way, the system may produce control signals that cause the reconfigurable Doherty power amplifier to be reconfigured into the full-power state or into a reduced-power state. In other words, according to some embodiments, traffic tracking may be performed on the traffic being processed by the amplifier system, and the selected amplifier state may be determined based on the instantaneously-measured traffic loading. In other embodiments, the relative traffic loading during various time ranges may be anticipated (rather than instantaneously measured), and the amplifier state may be selected based on temporal information (e.g., the current time of day, the current day of the week, or based on some other temporal information). In still other embodiments, the amplifier state may be selected based on other factors.

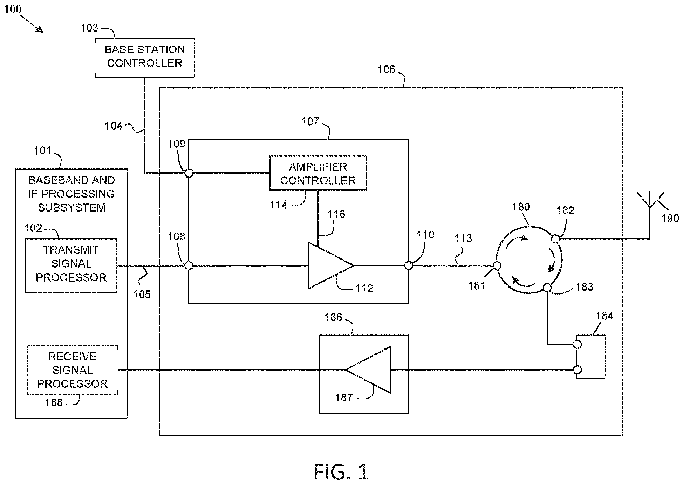

To provide context, FIG. 1 is a simplified block diagram of an example communication apparatus 100 in which an embodiment of a reconfigurable Doherty power amplifier (e.g., amplifier 112) may be incorporated. For example, the communication apparatus 100 may be implemented in a base station (not illustrated) of a cellular communication system (or in another apparatus associated with a cellular or other type of communication system). Communication apparatus 100 includes a baseband and intermediate frequency (IF) processing subsystem 101, a base station controller 103, a radio frequency (RF) transceiver 106, and an antenna 190.

The base station controller 103 includes hardware and associated software that is generally responsible for controlling the operations of the communication apparatus 100, including managing radio channels (e.g., allocating channels and optimizing the utilization of available resources), performing mobile device handovers, and performing call setups, among other things.

According to one or more embodiments, the base station controller 103 may perform traffic loading measurements (traffic tracking) on a periodic or continuous basis, and may provide control signals 104 to the RF transceiver 106 based on the traffic loading measurements. Based on the control signals 104 from the base station controller 103, the RF transceiver 106 (and more specifically, the amplifier controller 114) may reconfigure the output circuit of the amplifier 112 into one of multiple amplifier states (e.g., a full-power state or a reduced-power state), as will be discussed in more detail later.

The base station controller 103 may periodically or continuously measure or determine the instantaneous traffic loading condition of the system, and may compare the instantaneous traffic loading conditions to one or more thresholds to determine a traffic loading range in which the instantaneous traffic loading condition falls. Each of the traffic loading ranges may correspond to an amplifier state. The base station controller 103 may then provide a control signal (e.g., control signal 104) to the transmitter 107 that indicates the amplifier state corresponding to the current traffic loading. As will be described in detail below, the transmitter 107 then configures (or reconfigures) the amplifier (e.g., amplifier 112) in response to the control signal.

According to one or more other example embodiments, the base station controller 103 may maintain a look up table, which correlates time-of-day ranges to power levels (and/or amplifier states). For example, the base station controller 103 may determine a time-of-day range in which the current time of day falls. Each of the time-of-day ranges may correspond to one of multiple amplifier states. The base station controller 103 may then provide a control signal (e.g., control signal 104) to the transmitter 107 that indicates amplifier state corresponding to the current time of day. As will be described in detail below, the transmitter 107 then configures (or reconfigures) the amplifier (e.g., amplifier 112) in response to the control signal.

Referring again to FIG. 1, the baseband and IF processing subsystem 101 includes a transmit signal processor 102 and a receive signal processor 188. According to one or more embodiments, the transceiver 106 includes a transmitter 107, a circulator 180, an RF switch 184, and a receiver 186.

In a transmit mode of operation of system 100, the transmit signal processor 102 of the baseband and IF processing subsystem 101 performs baseband and IF processing to produce an RF transmit signal 105. The transmitter 107 receives and amplifies the RF transmit signal 105, and produces an amplified RF transmit signal 113, which ultimately will be transmitted over the air by antenna 190.

According to one or more embodiments, the transmitter 107 includes an RF signal input 108, a control signal input 109, a power amplifier 112, an amplifier controller 114, and an RF signal output 110. Through the RF signal input 108, the power amplifier 112 receives the RF transmit signal 105 from the transmit signal processor 102. According to one or more embodiments, the power amplifier 112 is a relatively high-gain amplifier, which amplifies the RF transmit signal 105, and produces an amplified RF transmit signal 113 at the RF signal output 110.

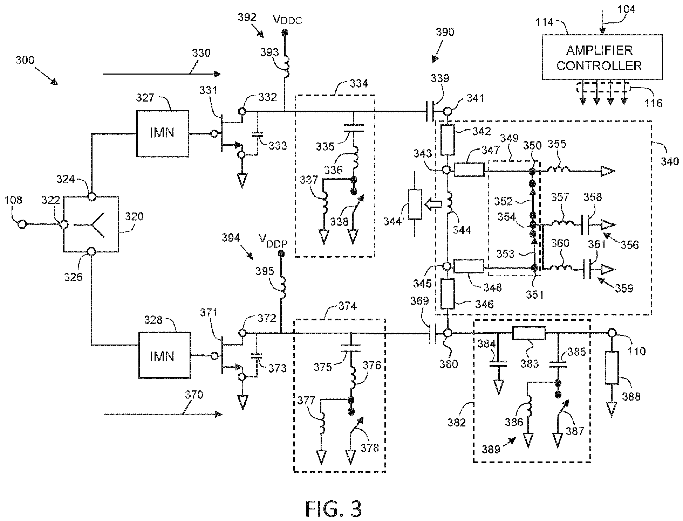

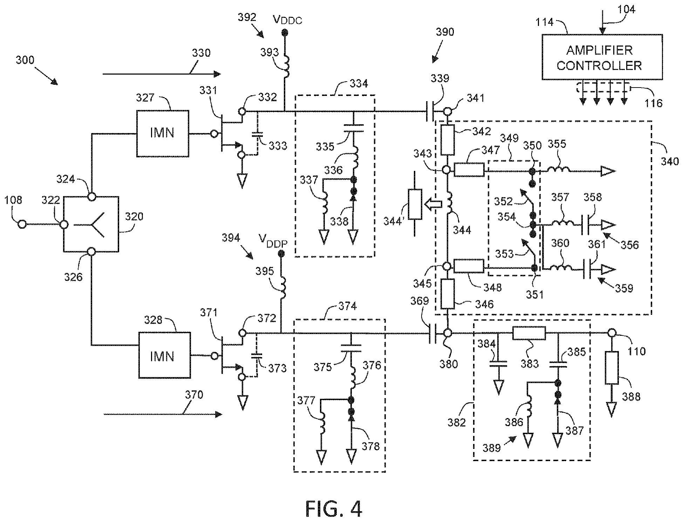

According to various embodiments, the power amplifier 112 may be a reconfigurable Doherty power amplifier (e.g., amplifier 300, FIGs 3, 4) with a reconfigurable output circuit (e.g., output circuit 390, FIGs 3, 4). As will be described in detail later, the configuration of the reconfigurable output circuit is established based on the control signals 104 received from the base station controller 103. As indicated above, the control signals 104 may indicate an amplifier state (e.g., state 1 or state 2). According to one or more embodiments, the amplifier controller 114 receives the control signals 104 from the base station controller 103 through the control signal input 109 (e.g., a serial-peripheral input (SPI) port, or another suitable control signal interface). Based on the control signals 104, the amplifier controller 114 may determine and provide additional control signals (e.g., switch control signals over switch control lines 116, FIGs 1, 3, 4) to the power amplifier 112, which may cause the power amplifier 112 to reconfigure its output circuit (e.g., output circuit 390, FIGs 3, 4). As will be described in more detail later, the reconfigurable output circuit of the power amplifier 112, enables the power amplifier 112 to amplify the RF transmit signal 105 in a linear and efficient manner over a wide range of average power levels and traffic loading conditions.

The amplified RF transmit signal 113 produced at the RF output 110 of transmitter 107 is conveyed to circulator 180. Circulator 180 includes a transmitter port 181, an antenna port 182, and a receiver port 183. The amplified RF transmit signal 113 is received at the transmitter port 181 of circulator 180. The circulator 180 may thereafter convey the amplified RF transmit signal 113 to the antenna port 182, which is coupled to antenna 190. Antenna 180 is configured to radiate the amplified RF transmit signal 113 over the air interface.

The circulator 180 is characterized by a signal-conduction directivity, which is indicated by the arrows within the depiction of circulator 180. Essentially, RF signals may be conveyed between the circulator ports 181-183 in the indicated direction (counter-clockwise), and not in the opposite direction (clockwise). Accordingly, during normal operations, signals may be conveyed through the circulator 180 from transmitter port 181 to antenna port 182, and from antenna port 182 to receiver port 183, but not directly from transmitter port 181 to receiver port 183 or from receiver port 183 to antenna port 182.

In a receive mode of operation, antenna 190 may receive RF signals over the air interface, and may provide the RF receive signals to the antenna port 182 of the circulator 180. The circulator 180 may then convey the RF receive signals to the receiver port 183 of the circulator 180. The receiver port 183 of circulator 180 may be coupled through the RF switch 184 to the receiver 186. The receiver 186 includes a receive amplifier 187 (e.g., a low noise amplifier), which amplifies the RF receive signals, and provides amplified RF receive signals to the receive signal processor 188 of the baseband and IF processing subsystem 101.

The RF switch 184 is optional, but is desirably included in order to ensure good isolation for the receiver 186. Particularly, in some situations, while the transceiver 106 is in the transmit mode of operation, the circulator 180 may not be able to convey signal energy received through the transmitter port 181 to the antenna 190 through antenna port 182. For example, the antenna 190 may be disconnected from the antenna port 182, or may otherwise be in a very high impedance state. In such situations, the circulator 180 may convey signal energy from the transmitter 107 (i.e., signal energy received through transmitter port 181) past the antenna port 182 to the receiver port 183. To avoid conveying transmitter signal energy into the receiver 186 while the transceiver 106 is in the transmit mode, the RF switch 184 may be operated as a fail-safe switch, which couples any transmitter signal energy to a ground reference node (not shown) while the transceiver 106 is in the transmit mode.

The configuration of the communication apparatus 100 shown in FIG. 1 is provided for context and example purposes. In other embodiments, the circulator 180 may be excluded, and an RF switch instead may be used to establish signal paths between the antenna 190 and either the transmitter 107 or the receiver 186 in a half-duplex manner. Other modifications also may be made to communication apparatus 100, as well.

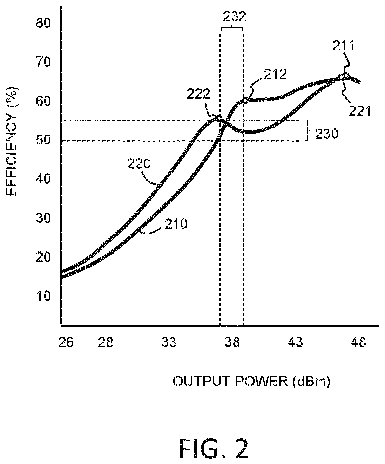

To better explain how the power amplifier 112 may be reconfigured to provide linear and efficient amplification over a wide range of average output power levels, reference is now made to FIG. 2, which is a graph 200 illustrating a two power efficiency curves 210, 220. Power efficiency curve 210 is associated with a first amplifier state (state 1 or "full-power" state) corresponding to full average output power condition, and power efficiency curve 220 is associated with a second amplifier state (state 2 or "reduced-power" state) corresponding to a reduced power condition. The horizontal axis of graph 200 corresponds to output power (in dBm), and the vertical axis of graph 200 corresponds to drain efficiency (in percent).

In the vernacular of Doherty power amplifiers, which will be used herein, "saturation output power", *P_{SAT}*, refers to the output power level at which the Doherty power amplifier enters saturation, and "backoff output power", *P_{BO}*, refers to a lower output power level along the same power efficiency curve at which a peaking amplifier of the Doherty power amplifier begins conducting (e.g., typically from about 6 dB to about 10 dB below *P_{SAT}*). Each amplifier state causes the reconfigurable Doherty power amplifier efficiency to be characterized by a different saturation output power, *P_{SAT}*, and a different backoff output power, *P_{BO}.* Accordingly, each power efficiency curve 210, 220 is characterized by a different saturation output power, *P_{SAT}*, and a different backoff output power, *P_{BO}.*

As used herein, "full" saturation output power, *P_{SAT-F}*, means a theoretically highest saturation output power, which is associated with an embodiment of a reconfigurable Doherty power amplifier that is configured in the full-power state (state 1). Similarly, as used herein, "full" backoff output power, *P_{BO-F}*, means a power level at which a first efficiency peak occurs below *P_{SAT-F}* while the amplifier is configured in the full-power state (e.g., at about 6 dB to about 10 dB below the full saturation output power, *P_{SAT-F}*).

Conversely, "reduced" saturation output power, *P_{SAT-R}*, means a saturation output power below the full saturation output power, and is associated with an embodiment of a Doherty power amplifier that is configured in the reduced-power state (state 2). Accordingly, "reduced" backoff output power, *P_{BO-R}*, means a power level at which a first efficiency peak occurs below *P_{SAT-R}* while the amplifier is configured in the reduced-power state.

Embodiments of reconfigurable Doherty power amplifiers discussed herein are configured to support a full-power state (corresponding to *P_{SAT-F}* and *P_{BO-F}*) and at least one reduced-power state. In such embodiments, a specific reduced-power state may be indicated with *P_{SAT-R}* and *P_{BO-R}.*

Referring to FIG. 2, power efficiency curve 210 corresponds to the full-power state (e.g., state 1). As indicated by curve 210, when an embodiment of a reconfigurable Doherty power amplifier is configured in the full-power state, the full saturation output power, *P_{SAT-F}*, is about 47 dBm, as indicated by circle 211, and the full backoff output power, *P_{BO-F}*, is about 38 dBm, as indicated by circle 212 (e.g., about 9 dB below the full saturation output power 211, *P_{SAT-F}*). Depending on various characteristics of the reconfigurable Doherty power amplifier (e.g., the frequency of operation, circuit topology, and other characteristics), the full saturation output power and the full backoff output power may have higher or lower values than those given above.

Power efficiency curve 220 corresponds to a reduced-power state (e.g., state 2). As indicated by curve 220, when an embodiment of a reconfigurable Doherty power amplifier is configured in the reduced-power state, the reduced saturation output power, *P_{SAT-R}*, is about 47 dBm, as indicated by circle 221, and the reduced backoff output power, *P_{BO-R}*, is about 36 dBm, as indicated by circle 222 (e.g., about 11 dBm below the reduced saturation output power 221, *P_{SAT-R}*). Again, depending on various characteristics of the reconfigurable Doherty power amplifier, the reduced saturation output power and the reduced backoff output power may have higher or lower values than those given above.

During operation of an embodiment of a reconfigurable Doherty power amplifier, the amplifier may be configured in an amplifier state (e.g., a full-power state) that has a power efficiency curve characterized by a relatively high *P_{SAT}* and a relatively high corresponding *P_{BO}* (e.g., curve 210) when higher traffic loading conditions are present, in order to support amplification at high average output power levels. Conversely, the amplifier may be configured in an amplifier state (e.g., a reduced-power state) that has a power efficiency curve characterized by a relatively low *P_{SAT}* and a relatively low corresponding *P_{BO}* (e.g., curve 220) when lower traffic loading conditions are present, in order to support amplification at lower average output power levels. The ability to reconfigure a Doherty power amplifier to operate with a reduced *P_{SAT}* and a reduced corresponding *P_{BO}* has the potential advantage of enabling efficient processing of signals with lower average output power levels (e.g., while traffic loading is relatively low), thus yielding overall power savings.

Embodiments of reconfigurable Doherty power amplifiers described herein include reconfigurable output circuits (e.g., output circuit 390, FIGs 3, 4) coupled between the outputs of the carrier and peaking amplifiers (e.g., amplifiers 331, 371, FIGs 3, 4) and the RF signal output (e.g., output 110, FIGs 3, 4). Embodiments of the reconfigurable output circuit include a combining node (e.g., combining node 380, FIGs 3, 4) and a reconfigurable impedance inverter circuit (e.g., circuit 340, 340', 340", FIGs 3-6) coupled between the carrier amplifier output and the combining node.

Embodiments of the reconfigurable impedance inverter circuit include an inductive element (e.g., element 344, 344', FIGs 3-6) coupled between first and second nodes, a switching circuit (e.g., circuit 349, 349', FIGs 3-6) with a first switching circuit terminal coupled to the first node and a second switching circuit terminal coupled to the second node, a fundamental frequency tuning circuit (e.g., circuit 356, FIGs 3-6) coupled between the switching circuit and a ground reference node, and a harmonic frequency resonance circuit (e.g., circuit 359, FIGs 3-6) coupled between the switching circuit and the ground reference node. When the switching circuit is configured in a first state, the fundamental frequency tuning circuit and the harmonic frequency resonance circuit are electrically coupled through the switching circuit to the first and second nodes, and when the switching circuit is configured in a second state, the fundamental frequency tuning circuit and the harmonic frequency resonance circuit are electrically disconnected from the first and second nodes.

Further embodiments of a reconfigurable Doherty power amplifier may include a reconfigurable carrier output capacitance circuit (e.g., circuit 334, FIGs 3, 4) coupled between the carrier amplifier output and the reconfigurable impedance inverter circuit, and a reconfigurable peaking output capacitance circuit (e.g., circuit 374, FIGs 3,4) coupled between the peaking amplifier output and the combining node. The reconfigurable carrier and peaking output capacitance circuits may be selectively configured to modify the effective values of drain-source capacitances, *C_{EFF_C}* and *C_{EFF_P}*, for the carrier and peaking amplifiers, respectively.

Additional embodiments of a reconfigurable Doherty power amplifier may include a reconfigurable output impedance transformer (e.g., transformer 382, FIGs 3, 4) coupled between the combining node and the amplifier output terminal (e.g., RF output 110, FIGs 3, 4). The reconfigurable output impedance transformer may be configured to modify the impedance at the combining node.

As used herein, "reconfigurable" means that various elements in a circuit may be controlled (e.g., switched into or out of the circuit) to configure the Doherty power amplifier into any of multiple amplifier states. Each amplifier state may be structured so that the amplifier achieves peak efficiencies (e.g., efficiencies of 60% or more) at full output power and at reduced output power.

For example, some embodiments reconfigurable Doherty power amplifiers include a reconfigurable output circuit that is able to be selectively configured into either of two amplifier states, with a first amplifier state being desirably selected for full average output power (e.g., 39.5 dBm or some other value), and a second amplifier state being desirably selected for a single reduced average output power level (e.g., 38.0 dBm or some other value).

For purposes of illustration only, and not by way of limitation, example Doherty power amplifier embodiments discussed in detail below have a 2:1 asymmetry ratio, and include reconfigurable 0 degree/90 degree (0/90) output circuits (i.e., approximately 0 degrees of electrical length couples the peaking amplifier intrinsic drain terminal and the combining node, and approximately 90 degrees of electrical length couples the carrier amplifier intrinsic drain terminal and the combining node). With a 2:1 asymmetry ratio, the size and power handling capability of the peaking amplifier, *P_{peaking}*, is about twice the size and power handling capability of the carrier amplifier, *P_{carrier}.* Other embodiments may include reconfigurable output circuits implemented in symmetric Doherty power amplifiers, or in asymmetric Doherty power amplifiers with different asymmetry ratios. Further, other embodiments may include reconfigurable output circuits with different electrical lengths between the carrier and peaking intrinsic drain terminals and the combining node (e.g., 90/180, 180/270, and so on). Further still, the Doherty power amplifier embodiments discussed herein correspond to "non-inverted" configurations in which the peaking input RF signal (at the input to the peaking amplifier 371) is delayed by about 90 degrees from the carrier input RF signal (at the input to the carrier amplifier 331) in order to compensate for about 90 degrees of phase delay that is applied to the amplified carrier output RF signal between the carrier amplifier output 332 and the combining node 380. Alternate embodiments may include "inverted" Doherty power amplifier configurations in which the carrier input RF signal (at the input to the carrier amplifier 331) is delayed by about 90 degrees from the peaking input RF signal (at the input to the peaking amplifier 371) in order to compensate for about 90 degrees of phase delay that is applied to the amplified peaking output RF signal between the peaking amplifier output 372 and the combining node 380. In the inverted Doherty power amplifier configuration, the reconfigurable impedance inverter circuit (e.g., circuits 340, 340', 340", FIGs 3-6) would be present between the peaking amplifier output 372 and the combining node 380, rather than between the carrier amplifier output 332 and the combining node 380.

Example component values that are provided below correspond to a 2:1 asymmetric Doherty power amplifier with a full saturation output power, *P_{SAT-F}*, of about 47 dBm, a full average output power level of about 39.5 dBm, and a first efficiency peak at a full backoff output power, *P_{BO-F}*, of about 38 dBm (i.e., about 9 dB below *P_{SAT-F}*). It should be understood that embodiments of Doherty power amplifiers may be designed with different asymmetry ratios (including symmetric Doherty power amplifiers), different full saturation output powers, different full average output power levels, and/or efficiency peaks at different full backoff output powers, and such Doherty power amplifier embodiments may have different component values than the example component values provided herein.

In addition, although embodiments of asymmetric Doherty power amplifiers are described in detail herein, it should be understood that other embodiments of reconfigurable Doherty power amplifiers may have a symmetric configuration (e.g., the relative sizes and power handling capabilities of the carrier and peaking amplifiers are equal). As used herein, the term "size," when referring to a physical characteristic of a power amplifier or power transistor, refers to the periphery or the power handling capability of the transistor(s) associated with that amplifier or transistor. The term "symmetric," when referring to the relative sizes and power handling capabilities of carrier and peaking amplifiers, means that the cumulative size of the power transistor(s) forming the carrier amplifier is/are substantially identical to (i.e., within 5%) the cumulative size of the power transistor(s) forming the peaking amplifier. Conversely, the term "asymmetric" means that the cumulative size of the power transistor(s) forming the peaking amplifier is from 25% greater to 200% greater (e.g., 100% greater) than the cumulative size of the power transistor(s) forming the carrier amplifier. Accordingly, for example, when the ratio of peaking amplifier size to carrier amplifier size (or the "peaking-to-carrier ratio") is denoted as *x:y* (where x corresponds to relative peaking amplifier size and *y* corresponds to relative carrier amplifier size), a ratio of 1:1 corresponds to a symmetric amplifier, and a ratio of 2:1 corresponds to an asymmetric amplifier, according to the above definitions. Further, as used herein, the term "shunt" means electrically coupled between a circuit node and a ground reference (or other DC voltage reference).

Additional details will now be provided for embodiments of reconfigurable Doherty power amplifiers (e.g., amplifier 112, FIG. 1) that are able to be dynamically configured into different states to modify the impedances at both 2*f₀* and *f₀*, and to achieve multiple power efficiency curves (e.g., power efficiency curves 210, 220, FIG. 2). As mentioned previously, the reconfigurable Doherty power amplifier embodiments include first and second LC networks that are selectively attachable to a reconfigurable impedance inverter circuit through a switching circuit. When the Doherty power amplifier is operating in a full-power state, the switches of the switching circuit are controlled to be closed to achieve the desired impedance of the inverter circuit. In this state, the switching circuit electrically couples the first and second LC networks to the reconfigurable impedance inverter circuit to provide a harmonic termination at the output of the carrier amplifier and thus to boost the full power baseline performance. When the Doherty power amplifier is operating in a reduced-power state, the switches are controlled to be open to achieve a different desired impedance (e.g., an impedance that is higher than that of the full-power state) of the inverter circuit. The first and second LC networks are therefore disconnected from the reconfigurable impedance inverter circuit. Under this scenario, the parasitic capacitance of each "off" state switch, together with the rest of inverter circuitry, provides a desirable load impedance for the carrier amplifier to achieve optimal performance at reduced power level.

According to one or more embodiments, and as will be discussed in detail below, the first LC network is configured to resonate at or near the second harmonic frequency, 2*f₀*, and the second LC network is configured to resonate at or near the fundamental frequency, *f₀*. The values of the first and second LC networks and the positions of the first and second LC networks along the reconfigurable quasi-line may be carefully selected to optimize the impedances at both 2*f₀* and *f₀.* With this approach, the efficiency of the Doherty power amplifier embodiments may be improved significantly, while maintaining the same bandwidth.

FIGs 3 and 4 are schematic drawings of a reconfigurable Doherty power amplifier 300 with a reconfigurable output circuit 390 that is capable of being selectively configured into at least a "full-power state" (FIG. 3) and a "reduced-power state" (FIG. 4), in accordance with an example embodiment. More specifically, FIG. 3 depicts the reconfigurable Doherty power amplifier 300 in a full-power state, in which the above-mentioned first and second LC networks (referred to below as a harmonic frequency resonance circuit 359 (or "2*f0* trap") and a fundamental frequency tuning circuit 356 (or "*f0* trap"), respectively) are electrically coupled (through a switching circuit 349) to a reconfigurable impedance inverter circuit 340. FIG. 4 depicts the reconfigurable Doherty power amplifier 300 in a reduced-power state in which the above-mentioned first and second LC networks are uncoupled (using switching circuit 349) from the reconfigurable impedance inverter circuit 340. For context, the reconfigurable Doherty power amplifier 300 may be used in a power amplifier (e.g., amplifier 112, FIG. 1) that forms a portion of the RF circuitry of a communication system.

Doherty power amplifier 300 includes an RF input 108, an RF output 110, power splitter 320, a carrier amplification path 330 with a carrier amplifier 331, a peaking amplification path 370 with a peaking amplifier 371, a reconfigurable output circuit 390 with a combining node 380, and a reconfigurable output impedance transformer 382. In an embodiment, an antenna 388 (or other type of load) is coupled to the RF output 110 (e.g., through a circulator (e.g., circulator 180, FIG. 1), an RF switch, or other circuitry). Although not shown, a DC blocking capacitor also may be coupled between the combining node 380 and the RF output 110.

Doherty power amplifier 300 is considered to be a "two-way" Doherty power amplifier, which includes one carrier amplification path 330 and one peaking amplification path 370. Essentially, the carrier amplifier 331 provides RF signal amplification along the carrier amplification path 330, and the peaking amplifier 371 provides RF signal amplification along the peaking amplification path 370. The amplified carrier and peaking RF signals are then conveyed through the reconfigurable output circuit 390 and combined at combining node 380 before provision through the reconfigurable output impedance transformer 382 to the RF output 110.

The power splitter 320 is configured to receive, at power splitter input 322, an input RF signal from RF input 108. The power splitter 320 is further configured to divide the power of the input RF signal into a carrier input signal RF and a peaking input RF signal, which are produced at power splitter outputs 324, 326, respectively. In this manner, the power splitter 320 is configured to provide the carrier input RF signal to the carrier amplification path 330, and to provide the peaking input RF signal to the peaking amplification path 370. In Doherty power amplifier 300, the power splitter 320 is configured so that, at the center frequency of operation, *f*0, of the amplifier 300, the input signal supplied to the peaking amplification path 370 is delayed by an input phase offset (e.g., about 90 degrees) with respect to the input signal supplied to the carrier amplification path 330.

Power splitter 320 may have any of a variety of configurations, including Wilkinson-type splitters, hybrid quadrature splitters, and so on. Power splitter 320 divides the power of the input RF signal according to a carrier-to-peaking size ratio. For example, when Doherty power amplifier 300 has a symmetric Doherty power amplifier configuration in which the carrier amplifier 331 and the peaking amplifier 371 are substantially equal in size, the power splitter 320 may divide the power such that about half of the input signal power is provided to the carrier amplification path 330, and about half of the input signal power is provided to the peaking amplification path 370. Conversely, when Doherty power amplifier 300 has an asymmetric Doherty power amplifier configuration, the power splitter 320 may divide the power unequally. For example, when the Doherty power amplifier 300 has a 2:1 peaking-to-carrier size ratio, the power splitter 320 may divide the input signal power so that approximately one third of the input signal power is provided to the carrier amplification path 330, and approximately two-thirds of the input signal power is provided to the peaking amplification path 370.

The carrier amplification path 330 includes a carrier input matching network (IMN) 327, the carrier amplifier 331, a reconfigurable carrier output capacitance circuit 334, and a reconfigurable impedance inverter circuit 340, according to one or more embodiments. Similarly, the peaking amplification path 370 includes a peaking IMN 328, the peaking amplifier 371, and a reconfigurable peaking output capacitance circuit 374. It may be noted here that the term "circuit," as used herein, is analogous to "electronic circuit", "circuitry," and "network."

The carrier and peaking IMNs 327, 328 are coupled between the power splitter outputs 324, 326 and the carrier and peaking amplifiers 331, 371, respectively. The carrier and peaking IMNs 327, 328 each may include, for example, lowpass or bandpass circuits configured as T- or pi- impedance matching networks, although other matching network topologies also are anticipated. However they are configured, the IMNs 327, 328 incrementally increase the circuit impedance toward the source impedance.

The carrier and peaking amplifiers 331, 371 each may be implemented as a power transistor (or a series of power transistors). Accordingly, each of the carrier and peaking amplifiers 331, 371 have a control input (e.g., a gate terminal) and two current-carrying terminals (e.g., drain and source terminals). First ones of the current-carrying terminals (e.g., the drain terminals) of the amplifiers 331, 371 function as outputs 332, 372 of the carrier and peaking amplifiers 332, 371, where amplified RF signals are produced by the amplifiers 331, 371. Second ones of the current-carrying terminals (e.g., the source terminals) of the amplifiers 331, 371 may be coupled to a ground reference node.

According to an embodiment, the first current-carrying terminals (e.g., drain terminals) each correspond to an intrinsic current generator (e.g., an intrinsic drain) of each amplifier 331, 371. Capacitances 333, 373 represent parasitic output capacitances (e.g., drain-source capacitances) present at the outputs of the carrier and peaking amplifiers 331, 371 (e.g., at the drain terminals of the carrier and peaking power transistors). In other words, the carrier amplifier output 332 is characterized by a drain-source capacitance 333 (or carrier amplifier output capacitance) between the drain and source terminals of the carrier amplifier 331. Similarly, the peaking amplifier output 372 is characterized by a drain-source capacitance 373 (or peaking amplifier output capacitance) between the drain and source terminals of the peaking amplifier 371. Although capacitances 333, 373 are not discrete physical components (e.g., discrete capacitors), capacitances 333, 373 are depicted in FIGs 3 and 4 to facilitate later discussion of how the reconfigurable output capacitance circuits 334, 374 may contribute to effective output capacitances, *C_{EFF_C}* and *C_{EFF_P}*, of the carrier and peaking amplifiers 331, 371. According to an embodiment, parasitic capacitances 333, 373 each have a capacitance value in a range of about 0.25 picofarads (pF) to about 20 pF, although the capacitance values may be lower or higher, as well.

The carrier amplifier 331 and the peaking amplifier 371 each include one or more power transistors (e.g., field effect transistors) embodied in a semiconductor die. In some embodiments, the semiconductor die(s) that include the carrier and peaking amplifiers 331, 371 may be packaged in a power amplifier device or a power amplifier module, along with all or portions of the carrier and peaking IMNs 327, 328 and the reconfigurable output circuits 334, 340, 374.

According to an embodiment, the carrier amplifier 331 and the peaking amplifier 371 each include a single-stage amplifier (i.e., an amplifier with a single amplification stage or power transistor). In other embodiments, the carrier amplifier 331 is a two-stage amplifier, which includes a relatively low-power driver amplifier (not shown) and a relatively high-power final-stage amplifier (not shown) connected in a cascade (or series) arrangement between the carrier amplifier input and the carrier amplifier output. Similarly, the peaking amplifier 371 may include a two-stage amplifier, which includes a relatively low-power driver amplifier (not shown) and a relatively high-power final-stage amplifier (not shown) connected in a cascade arrangement between the peaking amplifier input and the peaking amplifier output.

Various DC bias circuits are coupled to the inputs and to the outputs of the carrier and peaking amplifiers 331, 371, in order to convey DC bias voltages that will ensure proper operation of the Doherty power amplifier 300. FIG. 3 does not show gate bias circuits, but does show carrier and peaking drain bias circuits 392, 394, respectively. More specifically, during operation of Doherty power amplifier 300, the carrier amplifier 331 is biased to operate in class AB mode or deep class AB mode, and the peaking amplifier 371 is biased to operate in class C mode or deep class C or class J mode. In some configurations, the peaking amplifier 371 may be biased to operate in class B mode.

For example, output DC bias circuits 392, 394 may be coupled to the outputs (e.g., drain terminals) of the carrier and peaking amplifiers 331, 371, respectively, and the output DC bias circuits 392, 394 are configured to convey drain bias voltages, *V_{DDC}* and *V_{DDP}*, to the outputs (e.g., drain terminals) of the carrier and peaking amplifiers 331, 371, respectively. Each output DC bias circuit 392, 394 may include a bias inductor 393, 395, according to one or more embodiments. The bias inductors 393, 395 may affect the effective output capacitances, *C_{EFF_C}* and *C_{EFF_P}*, of each of the carrier and peaking amplifiers 331, 371. When amplifier 300 is a symmetrical Doherty power amplifier with substantially equal parasitic output capacitances 333, 373, the bias inductors 393, 395 may have substantially equal inductance values. Conversely, when amplifier 300 is an asymmetrical Doherty power amplifier with unequal parasitic output capacitances 333, 373 (e.g., the parasitic output capacitance 373 of the peaking amplifier 371 may be about twice the parasitic output capacitance 333 of the carrier amplifier 331 for a 2:1 Doherty power amplifier), the bias inductors 393, 395 may have unequal inductance values, which cause the effective output capacitances, *C_{EFF_C}* and *C_{EFF_P}*, for the carrier and peaking amplifiers 331, 371, respectively, to be equal.

The carrier amplifier 331 is configured to amplify the carrier input RF signal produced at splitter output 324, and to produce an amplified carrier output RF signal at the carrier amplifier output 332 (e.g., the carrier amplifier intrinsic drain terminal). Similarly, the peaking amplifier 371 is configured to amplify the peaking input RF signal produced at splitter output 326, and to produce an amplified peaking output RF signal at the peaking amplifier output 372 (e.g., the peaking amplifier intrinsic drain terminal).

The carrier and peaking amplifier outputs 332, 372 are coupled through a reconfigurable output circuit 390 and, in some embodiments, through a reconfigurable output impedance transformer 382, to the RF output 110. According to one or more embodiments, the reconfigurable output circuit 390 includes a combining node 380, a reconfigurable carrier output capacitance circuit 334 coupled to the carrier amplifier output 332, a reconfigurable impedance inverter circuit 340 (or reconfigurable quasi-line) coupled between the carrier amplifier output 332 and the combining node 380, and a reconfigurable peaking output capacitance circuit 374 coupled to the peaking amplifier output 372 and to the combining node 380.

The reconfigurable circuits 334, 340, 374 are configured to function as an impedance inverter. Generally, and as will be described in more detail below, the impedance inverter includes a first shunt capacitance (carrier drain-source capacitance 333 as modified by the reconfigurable carrier output capacitance circuit 334), a series inductance (reconfigurable impedance inverter circuit 340), and a second shunt capacitance (peaking drain-source capacitance 373 as modified by the reconfigurable peaking output capacitance circuit 354). In other words, the circuit formed by reconfigurable circuits 334, 340, and 374 is a PI network consisting of a shunt C (parasitic capacitance 333 and circuit 334), a series L (circuit 340), and a shunt C (parasitic capacitance 373 and circuit 374). Theoretically, the best performance of amplifier 300 (e.g., optimal bandwidth) may be achieved when the capacitance values of the shunt C circuits are substantially equal (i.e., *C_{EFF_C} = C_{EFF_P}*). As will also be described in more detail below, during operation of amplifier 300, the reconfigurable circuits 334, 340, 374 are controlled synchronously to establish impedance inverter configurations that will achieve desired peak efficiency power levels. The reconfigurability of the reconfigurable circuits 334, 340, 374 enables the correct / proper impedances to be established at the carrier and peaking amplifier outputs 332, 372 (i.e., the drain terminals of amplifiers 331, 371), which may ensure optimal signal amplification and post combining at full and reduced average output power levels.

As mentioned above, each of the carrier and peaking amplifiers 331, 371 is characterized by a parasitic drain-source capacitance 333, 373. According to one or more embodiments, the reconfigurable carrier output capacitance circuit 334 functions to modify the parasitic drain-source capacitance 333 of the carrier amplifier 331, resulting in an effective output capacitance, *C_{EFF_C}*, at the carrier amplifier output 332 that is different from (e.g., lower than) the parasitic drain-source capacitance 333. Similarly, the reconfigurable peaking output capacitance circuit 374 functions to modify the parasitic drain-source capacitance 373 of the peaking amplifier 371, resulting in an effective output capacitance, *C_{EFF_P}*, at the peaking amplifier output 372 that is different from (e.g., lower than) the parasitic drain-source capacitance 373.

During operation, shunt inductances provided by the reconfigurable carrier and peaking output capacitance circuits 334, 374 function to resonate out some of the parasitic drain-source capacitances 333, 373. In other words, the carrier amplifier effective output capacitance, *C_{EFF_C}* (or the first shunt capacitance of the impedance inverter), is defined by the carrier amplifier parasitic drain-source capacitance 333 as modified by the reconfigurable carrier output capacitance circuit 334, and the peaking amplifier effective output capacitance, *C_{EFF_P}* (or the second shunt capacitance of the impedance inverter), is defined by the peaking amplifier parasitic drain-source capacitance 373 as modified by the reconfigurable peaking output capacitance circuit 374. It may be noted here that the peaking amplifier effective output capacitance, *C_{EFF_P}*, also may be affected by the capacitance value of a later-described reconfigurable output impedance transformer 382.

According to one or more embodiments, in order to achieve optimal performance, the effective output capacitances, *C_{EFF_C}* and *C_{EFF_P}*, associated with the carrier and peaking amplifiers 331, 371 may be controlled to be equal or approximately equal to each other, regardless of whether the Doherty power amplifier 300 is a symmetric or an asymmetric Doherty power amplifier. In other embodiments, the effective output capacitances, *C_{EFF_C}* and *C_{EFF_P}*, may be controlled to be different from each other, while still achieving at least some of the benefits described herein.

In the embodiment illustrated in FIGs 3 and 4, the reconfigurable carrier output capacitance circuit 334 includes a reconfigurable shunt circuit coupled between the carrier amplifier output 332 and a ground reference node. Similarly, the reconfigurable peaking output capacitance circuit 374 includes a reconfigurable shunt circuit coupled between the peaking amplifier output 372 and the ground reference node.

Each reconfigurable carrier and peaking output capacitance circuit 334, 374 includes a DC blocking capacitor 335, 375 coupled in series with a first inductive element 336, 376 between the carrier or peaking amplifier output 332, 372 and an intermediate node (not numbered). In addition, each reconfigurable carrier and peaking output capacitance circuit 334, 374 includes a second inductive element 337, 377 coupled in parallel with a bypass switching element 338, 378 between the intermediate node and a ground reference node. More specifically, a first terminal of each capacitor 335, 375 is coupled to the carrier or peaking amplifier output 332 or 372, and a second terminal of each capacitor 335, 375 is coupled to a first terminals of a first inductive element 336, 376, and a second terminal of each first inductive element 336, 376 is coupled to an intermediate node. In addition, a first terminal of each second inductive element 337, 377 and a first terminal of each bypass switching element 338, 378 is coupled to an intermediate node, and a second terminal of each second inductive element 337, 377 and of each bypass switching element 338, 378 is coupled to the ground reference node.

In the full-power state, when switching elements 338, 378 are open, as shown in FIG. 3, the serial inductances provided by inductive elements 336 + 337 and 376 + 377 function to resonate out a portion of the parasitic drain-source capacitances 333, 373, thus reducing *C_{EFF_C}* and *C_{EFF_P}*, respectively. In the reduced-power state, when switching elements 338, 378 are closed, as shown in FIG. 4, inductive elements 337 and 377 are bypassed by the switching elements 338, 378, and the serial inductances provided only by inductive elements 336 and 376 function to resonate out a lesser portion of the parasitic drain-source capacitances 333, 373, thus reducing *C_{EFF_C}* and *C_{EFF_P}*, respectively, by a smaller amount.

The capacitance and inductance values selected for capacitors 335, 375 and inductive elements 336, 337, 376, 377 may be based on the fundamental frequency of operation of the amplifier 300, *f*₀. For example, *f*₀ may be in a range of about 800 megahertz (MHz) to about 7 gigahertz (GHz), although *f*₀ may be lower or higher, as well. According to one or more embodiments, each of the capacitors 335, 375 has a capacitance value in a range of about 3 pF to about 22 pF, and each of the inductive elements 336, 337, 376, 377 has an inductance value in a range of about 0.25 nanohenries (nH) to about 12 nH, although the capacitance and/or inductance values may be lower or higher, as well.

According to one or more embodiments, the reconfigurable carrier and peaking output capacitance circuits 334, 374 may have similar or identical circuit topologies. For example, in embodiments in which the Doherty power amplifier 300 is a symmetric amplifier, corresponding capacitors in the reconfigurable carrier and peaking output capacitance circuits 334, 374 may have equal capacitance values (e.g., capacitors 335, 375 may have equal capacitance values), corresponding first and second inductive elements in the reconfigurable carrier and peaking output capacitance circuits 334, 374 may have equal inductance values (e.g., inductive elements 336, 376 may have equal inductance values, and inductive elements 337, 377 may have equal inductance values). Conversely, in embodiments in which the Doherty power amplifier 300 is an asymmetric amplifier, corresponding capacitors in the reconfigurable carrier and peaking output capacitance circuits 334, 374 may have unequal but scaled capacitance values (e.g., for a 2:1 peaking-to-carrier ratio, capacitor 375 may have twice the capacitance value as capacitor 335). Further, corresponding first and second inductive elements in the reconfigurable carrier and peaking output capacitance circuits 334, 374 may have unequal but scaled inductance values (e.g., for a 2:1 peaking-to-carrier ratio, inductive elements 376 and 377 may have twice the inductance values as inductive elements 336 and 337, respectively).

Capacitor 339 is coupled between the carrier amplifier output 332 (and the reconfigurable carrier output capacitance circuit 334) and the reconfigurable impedance inverter circuit 340, and capacitor 369 is coupled between the peaking amplifier output 372 (and the reconfigurable peaking output capacitance circuit 374) and the combining node 380. Capacitors 339, 369 function as DC blocking capacitors, and also contribute to the impedance matching between the carrier and peaking amplifier outputs 332, 372 and the combining node 380.

As shown in FIGs 3 and 4, a series inductance of the reconfigurable output circuit 390 is provided by the reconfigurable impedance inverter circuit 340. The reconfigurable impedance inverter circuit 340 basically includes a series circuit and a shunt circuit coupled between the carrier amplifier output 332 and the combining node 380.

More specifically, the series circuit of the reconfigurable impedance inverter circuit 340 includes an input node 341, a first transmission line segment 342, a first intermediate node 343, a first inductive element 344, a second intermediate node 345, and a second transmission line segment 346 coupled in series between the carrier amplifier output 332 and the combining node 380. More specifically, the input node 341 is coupled through the DC blocking capacitor 339 to the carrier amplifier output 332. A first end of the first transmission line segment 342 is coupled to the input node 341, and a second end of the first transmission line segment 342 is coupled to the first intermediate node 343. A first terminal of the first inductive element 344 is coupled to the first intermediate node 343, and a second terminal of the first inductive element 344 is coupled to the second intermediate node 345. A first end of the second transmission line segment 346 is coupled to the second intermediate node 345, and a second end of the second transmission line segment 346 is coupled to the combining node 380.

Inductive element 344 may include, for example, a discrete inductor. In other embodiments, inductive element 344 may be a transmission line segment (e.g., transmission line segment 344' shown to the left of inductive element 344). Either way, inductive element 344 (or transmission line segment 344') is characterized by an electrical length and a characteristic impedance, referred to herein as *Z*₃₄₄.

The shunt circuit of the reconfigurable impedance inverter circuit 340 includes a third transmission line segment 347, a fourth transmission line segment 348, a switching circuit 349, a second inductive element 355, a fundamental frequency tuning circuit 356, and a harmonic frequency resonance circuit 359. More specifically, the third transmission line segment 347 has a first end coupled to the first intermediate node 343 and a second end coupled to a first switching circuit terminal 350 of the switching circuit 349. The fourth transmission line segment 348 has a first end coupled to the second intermediate node 345 and a second end coupled to a second switching circuit terminal 351 of the switching circuit 349.

The third transmission line segment 347 and the second inductive element 355 are coupled in series between the first intermediate node 343 and a ground reference node. The series combination of the third transmission line segment 347 and the second inductive element 355 form a shunt circuit that contributes to the impedance matching/transformation between the carrier amplifier output 332 and the combining node 380. According to one or more embodiments, the second inductive element 355 (e.g., a discrete inductor, a transmission line segment, or a set of wirebonds) has an inductance value in a range of about 3 nH to about 9 nH, although the inductance value may be lower or higher, as well.

In the embodiment of FIGs 3 and 4, the switching circuit 349 includes the first switching circuit terminal 350, the second switching circuit terminal 351, a first switching element 352 coupled between the first switching circuit terminal 350 and an intermediate node 354, and a second switching element 353 coupled between the intermediate node 354 and the second switching circuit terminal 351. The fundamental frequency tuning circuit 356 and the harmonic frequency resonance circuit 359 both are coupled between the intermediate node 354 and a ground reference node.

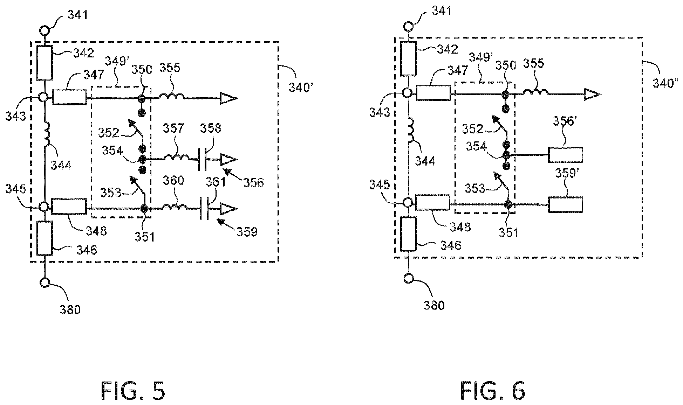

Referring briefly to FIG. 5, in an alternate embodiment of a reconfigurable impedance inverter circuit 340' (which may replace circuit 340 in FIGs 3, 4), the switching circuit 349' includes the first switching circuit terminal 350, the second switching circuit terminal 351, the first switching element 352 coupled between the first switching circuit terminal 350 and an intermediate node 354, and the second switching element 353 coupled between the intermediate node 354 and the second switching circuit terminal 351. In contrast with the embodiments of FIGs 3 and 4, however, in the embodiment of FIG. 5, the harmonic frequency resonance circuit 359 is coupled between the second switching circuit terminal 351 and a ground reference node, and the fundamental frequency tuning circuit 356 is coupled between the intermediate node 354 and a ground reference node.

In all of the embodiments of FIGs 3-5, and according to one or more embodiments, the harmonic frequency resonance circuit 359 includes an LC network, which includes an inductive element 360 (e.g., a discrete inductor, a transmission line segment, or a set of wirebonds) and a capacitor 361 coupled in series between the intermediate node 354 and the ground reference node. As shown in FIGs 3, 4, a first terminal of the inductive element 360 is coupled to the intermediate node 354, and a second terminal of the inductive element 360 is coupled to a first terminal of the capacitor 361. A second terminal of the capacitor 361 is coupled to the ground reference node. It should be noted that the series order of the inductive element 360 and the capacitor 361 in circuit 359 may be reversed from the order in which they are shown in FIGs 3 and 4. Referring briefly to FIG. 6, in an alternate embodiment, of a reconfigurable impedance inverter circuit 340", the harmonic frequency resonance circuit 359 of FIGs 3-5 is replaced with a first shunt stub 359' (also referred to as harmonic frequency resonance circuit 359').

Either way, the harmonic frequency resonance circuit 359, 359' is configured to resonate at or near a second harmonic frequency of the fundamental frequency of operation, *f₀*, of the amplifier 300, or at 2*f₀* (e.g., where "at or near" means at precisely the second harmonic frequency, 2*f₀*, or at a frequency between about 90 percent and about 110 percent of 2*f₀*). According to one or more embodiments, the inductive element 360 has an inductance value in a range of about 0.5 nH to about 1.0 nH, and the capacitor 361 has a capacitance value in a range of about 0.3 pF to about 1.0 pF, although the inductance and/or capacitance values may be lower or higher, as well.

According to one or more embodiments, the shunt circuit of the reconfigurable impedance inverter circuit 340, 340' also includes the above-mentioned fundamental frequency tuning circuit 356 coupled between the intermediate node 354 of the switching circuit 349 and the ground reference node. More specifically, the fundamental frequency tuning circuit 356 may be an LC network, which includes an inductive element 357 (e.g., a discrete inductor, a transmission line segment, or a set of wirebonds) and a capacitor 358 coupled in series between the intermediate node 354 and the ground reference node. As shown in FIGs 3, 4, a first terminal of the inductive element 357 is coupled to the intermediate node 354, and a second terminal of the inductive element 357 is coupled to a first terminal of the capacitor 358. A second terminal of the capacitor 358 is coupled to the ground reference node. It should be noted that the series order of the inductive element 357 and the capacitor 358 in circuit 356 may be reversed from the order in which they are shown in FIGs 3 and 4. Referring again briefly to FIG. 6, in an alternate embodiment, of a reconfigurable impedance inverter circuit 340", the fundamental frequency tuning circuit 356 of FIGs 3-5 is replaced with a second shunt stub 356' (also referred to as fundamental frequency tuning circuit 356').

The harmonic frequency resonance circuit 359, 359' essentially is capacitive at the fundamental frequency, *f₀*, and the resonant network (i.e., the inductive element 357 and the capacitor 358 or the second shunt stub 356') of the fundamental frequency tuning circuit 356, 356' functions to counteract the capacitive nature of the harmonic frequency resonance circuit 359, 359' at *f₀* by behaving like a shunt inductance in parallel with the capacitive harmonic frequency resonance circuit 359. In other words, the harmonic frequency resonance circuit 359, 359' is primarily characterized by a capacitance at *f₀*, and the fundamental frequency tuning circuit 356, 356' is primarily characterized by an inductance at *f₀.* Accordingly, when the switching circuit 349 (or 349') is configured in the full-power state, the inductance of the fundamental frequency tuning circuit 356, 356' counteracts the capacitance of the harmonic frequency resonance circuit 359, 359'. According to one or more embodiments, the fundamental frequency tuning circuit 356, 356' is configured to resonate at or near the fundamental frequency of operation, *f₀,* of the amplifier 300 (e.g., where "at or near" means at precisely the fundamental frequency, *f₀*, or at a frequency between about 90 percent and about 110 percent of *f₀*).

By way of explanation, both the fundamental frequency tuning circuit 356, 356' (or "*f0* trap") and the harmonic frequency resonance circuit 359, 359' (or "2*f0* trap") are located along the reconfigurable impedance inverter circuit 340 (i.e., along the reconfigurable quasi-line), and their locations may be designed to be relatively electrically close to the combining node 380 and peaking amplifier 371. Therefore, according to one or more embodiments, a 2*f0* (short) will be transferred through the 90 degree (referenced to *f0*) quasi-line to the carrier amplifier output 332 (e.g., drain terminal) as a 2*f0* short. On the contrary, a *f0* short will be transferred as an open to the carrier amplifier output 332 through the reconfigurable impedance inverter circuit 340 (i.e., through the reconfigurable quasi-line). Therefore, these *f0* and 2*f0* traps along the reconfigurable impedance inverter circuit 340 jointly form a 2*f0* termination and an open at *f0* to ensure the *f0*/2*f0* network will not affect the fundamental matching of the Doherty power amplifier 300. Depending on the locations of the 2*f0*/*f0* traps along the reconfigurable impedance inverter circuit 340 (i.e., along the reconfigurable quasi-line), there are certain frequency ranges for both the 2*f0* and *f0* trap resonant frequencies. According to one or more embodiments, in order to achieve the desired resonances, the inductive element 355 has an inductance value in a range of about 1 nH to about 3.0 nH, and the capacitor 358 has a capacitance value in a range of about 1.0 pF to about 2.0 pF, although the inductance and/or capacitance values may be lower or higher, as well.

As mentioned above, inductive element 344 (or transmission line segment 344') is characterized by an electrical length and a characteristic impedance, *Z*₃₄₄. Further, each of the first, second, third, and fourth transmission line segments are characterized by an electrical length, *β*, and a characteristic impedance, Z. As used herein, the characteristic impedances of transmission line segments 342, 346, 347, 348 may be referred to as *Z*₃₄₂, *Z*₃₄₆, *Z*₃₄₇, *Z*₃₄₈. The electrical lengths of the transmission line segments 342, 346, 347, 348 may be equal or unequal, and the characteristic impedances of the transmission line segments 342, 346, 347, 348 may be equal or unequal.

The total impedance value, *Z*_{TOT}, of the reconfigurable impedance inverter circuit 340, 340', 340" depends on the state of the switching circuit 349, 349', and more particularly on whether or not the harmonic frequency resonance circuit 359, 359' and the fundamental frequency tuning circuit 356, 356' are coupled to the reconfigurable impedance inverter circuit 340, 340', 340" through the switching circuit 349, 349'.

Embodiments of the reconfigurable impedance inverter circuits 340, 340', 340" may be designed to achieve an impedance inverter that is characterized by the same phase but different characteristic impedances in the full-power state and in the reduced-power state. In general, when the reconfigurable impedance inverter circuit 340, 340', 340" is configured in the reduced-power state, the total impedance value, *Z_{TOT}*, of the reconfigurable impedance inverter circuit 340, 340', 340" between the carrier amplifier output 332 and the combining node 380 is higher than that it is when the reconfigurable impedance inverter circuit 340, 340', 340" is configured in the full-power state. As an illustrative approximation, if the amplifier 300 is configured so that the reduced-power state is *x* dB backed off from the full-power state, a ratio of the reduced-power state *Z*_{TOT} (herein "*Z*_{*TOT*_}red") to the full-power state *Z*_{TOT} (herein "*Z*_{*TOT*_}full") may be about 10^(*x*/10). For example, if the reduced-power state is 3 dB backed off from the full-power state, *Z*_{TOT}_red = 2* *Z*_{TOT}_full.

The impedance values and electrical lengths selected for the transmission line segments 342, 346, 347, 348 may be based on the fundamental frequency of operation of the amplifier 300, *f*₀ (e.g., about 800 MHz to about 7 GHz). According to one or more embodiments, each of the parallel transmission line segments 342, 346, 347, 348 has an impedance value in a range of about 20 Ohms to about 100 Ohms, although the impedance values may be lower or higher, as well. Further, according to one or more embodiments, each of the transmission line segments 342, 346, 347, 348 has an electrical length in a range of about 10 degrees to about 40 degrees, although the electrical lengths may be lower or higher, as well. According to one or more embodiments, the electrical lengths of the transmission line segments 342, 346, 347, 348 are selected so that the total electrical length between the output 332 of the carrier amplifier 332 and the combining node 380 is about 90 degrees for signal energy at the fundamental frequency of operation, *f₀*. Additionally, according to one or more embodiments, the electrical lengths of transmission line segments 347, 348 (and switches 352, 353) are designed so that the total electrical length of these series-coupled components is approximately equal to the electrical length of inductive element 344 (or transmission line segment 344'). In various embodiments, the characteristic impedance of the inductive element 344 and the transmission line segments 347, 348 (and switches 352, 353) may be the same or different.

As mentioned previously, the switching elements 338, 352, 353, 378, 387 are not ideal components, and each is characterized by some degree of loss. According to one or more embodiments, each of the switching elements 338, 352, 353, 378, 387 may be implemented as an active switching device (e.g., a field effect transistor (FET)) with a control terminal (e.g., a gate terminal) and current conducting terminals (e.g., drain and source terminals). For example, the switching elements 338, 352, 353, 378, 387 may include metal oxide semiconductor FETs (MOSFETs), high electron mobility transistors (HEMTs), metal-semiconductor field effect transistors (MESFETs), laterally diffused metal-oxide semiconductor (LDMOS) FETs, Enhancement-mode MOSFETs (EMOSFETs), and/or junction gate FETs (JFETs), to name a few.

During operation of Doherty power amplifier 300, the state of the reconfigurable impedance inverter circuit 340, 340', 340" may be controlled into the full-power state (state 1, FIG. 3) or into the reduced-power state (state 2, FIGs 4-6) by controlling the switching elements 352, 353 of the switching circuit 349, 349'. According to one or more embodiments, the switching elements 352, 353 are controlled synchronously. Said another way, to establish either the full-power state or the reduced-power state configurations for the amplifier 300, the states of switching elements 352, 353 are controlled by the amplifier controller 114 in a synchronous manner. Each of the switching elements 352, 353 may be "turned off" or "opened" (e.g., placed in a state of high impedance between drain and source terminals) or "turned on" or "closed" (e.g., placed in a state of low impedance between drain and source terminals) based on switch control signals provided to the control terminal of the switching element.

More specifically, to place the Doherty power amplifier into the full-power state, the switching elements 352, 353 are simultaneously controlled into a closed (low impedance) state. In this full-power state, the harmonic frequency resonance circuit 359, 359' and the fundamental frequency tuning circuit 356, 356' are both electrically connected to the reconfigurable impedance inversion circuit 340, 340', 340" at a point between the third and fourth transmission line segments 347, 348. Further, the reconfigurable quasi-line of the reconfigurable impedance inversion circuit 340, 340', 340" includes transmission line segments 342, 347, 348, and 346, with inductive element 344 (or transmission line segment 344') coupled in parallel with transmission line segments 347 and 348. Conversely, to place the Doherty power amplifier into the reduced-power state, the switching elements 352, 353 are simultaneously controlled into an open (high impedance) state. In this reduced-power state, the harmonic frequency resonance circuit 359, 359' and the fundamental frequency tuning circuit 356, 356' are both electrically disconnected from the reconfigurable impedance inversion circuit 340, 340', 340". Further, the reconfigurable quasi-line of the reconfigurable impedance inversion circuit 340, 340', 340" includes only transmission line segment 342, inductive element 344 (or transmission line segment 344'), and transmission line segment 346. In other words, in the reduced-power state, the inductive element 344 is activated to take the load off of the portion of the quasi-line corresponding to transmission line segments 347, 348.

According to an embodiment, a reconfigurable output impedance transformer 382 is coupled between the combining node 380 and the RF output 110. During operation of amplifier 300, the reconfigurable output impedance transformer 382 is configured to transform the impedance at RF output 110 to the impedance at combining node 380. Accordingly, the impedance at the combining node 380 is established by the reconfigurable output impedance transformer 382. Specifically, the impedance at the combining node 380 is dependent on the power level where it is desired to have the first efficiency peak (e.g., points 212, 222, FIG. 2). During operation, the reconfigurable output impedance transformer 382 is controlled to establish the correct combining node impedance for the desired power level in reduced power conditions.

According to one or more embodiments, the reconfigurable output impedance transformer 382 includes a phase shift element 383 (e.g., a transmission line segment or an inductor) with a first end (or first terminal) coupled to the combining node 380, and a second end (or second terminal) coupled to the RF output 110. The phase shift element 383 is characterized by a characteristic impedance, *Z*₁, and an electrical length (or phase shift) at the center frequency of operation, *f₀*, of the amplifier 300. For example, the impedance, *Z₁*, may be in a range of about 20 to about 100, and the electrical length may be in a range of about 15 degrees to about 90 degrees, although the electrical length may be shorter or longer, as well.

In addition to the phase shift element 383, the reconfigurable output impedance transformer 382 also includes a shunt capacitor 384 coupled between the first end of the phase shift element 383 and a ground reference node, and a reconfigurable LC circuit 389 coupled between the second end of the phase shift element 383 and the ground reference node. According to one or more embodiments, the reconfigurable LC circuit 389 includes a capacitor 385 and an inductive element 386 coupled in series between the second end of the phase shift element 383 and the ground reference node. In addition, the reconfigurable LC circuit 389 includes a bypass switching element 387 with a first terminal coupled to a node (not numbered) between the capacitor 385 and the inductive element 386, and a second terminal coupled to the ground reference node.

In the full-power state, when switching element 387 is open, as shown in FIG. 3, the reconfigurable output impedance transformer 382 essentially includes the shunt capacitor 384, the transmission line segment 383, and the series-coupled, shunt capacitor 385 and inductive element 386. This configuration establishes a first characteristic impedance for the reconfigurable output impedance transformer 382. Conversely, in the reduced-power state, when switching element 397 is closed, as shown in FIG. 4, inductive element 386 is bypassed by the switching element 387. Thus, in the reduced-power state, the reconfigurable output impedance transformer 382 essentially includes the shunt capacitor 384, the transmission line segment 383, and the shunt capacitor 385. This configuration establishes a second and different characteristic impedance for the reconfigurable output impedance transformer 382.

The capacitance and inductance values selected for capacitors 384, 385 and inductive element 386 may be based on the fundamental frequency of operation of the amplifier 300,*f*₀. According to one or more embodiments, each of the capacitors 384, 385 has a capacitance value in a range of about 0.5 pF to about 1.0 pF, and inductive element 386 has an inductance value in a range of about 0.25 nH to about 6.0 nH, although the capacitance and/or inductance values may be lower or higher, as well.

According to one or more embodiments, the reconfigurable output impedance transformer 382 is controlled to establish a desired impedance, *Z₀*, at the combining node 380 that corresponds to the amplifier state (e.g., full-power state or a reduced-power state). For example, the reconfigurable output impedance transformer 382 may be controlled to establish a relatively low combining node impedance, *Z₀* (e.g., from 10-15 ohms) when the reconfigurable Doherty power amplifier 300 is in the full-power state, and the reconfigurable output impedance transformer 382 may be controlled to establish a relatively high combining node impedance, *Z₀* (e.g., from 20-30 ohms) when the reconfigurable Doherty power amplifier 300 is in a reduced-power state. According to an embodiment, the reconfigurable output impedance transformer 382 is controlled to double the combining node impedance, *Z₀*, in the reduced-power state.

According to one or more embodiments, the reconfigurable carrier and peaking output capacitance circuits 334, 374, and the reconfigurable output impedance transformer 382 may be reconfigured synchronously with the reconfiguration of the reconfigurable output impedance transform circuit 340, 340', 340" (e.g., through switch control signals provided over switch control lines 116). More specifically, to place the Doherty power amplifier into the full-power state (FIG. 3), the switching elements 338, 378, 387 are simultaneously controlled into an open (high impedance) state. In this full-power state, inductive elements 336 and 337 function to resonate out some of drain-source capacitance 333, and inductive elements 376, 377 function to resonate out some of drain-source capacitance 373. Additionally, inductive element 386 affects the characteristic impedance of the reconfigurable output impedance transformer circuit 382. Conversely, to place the Doherty power amplifier into the reduced-power state (FIG. 4), the switching elements 338, 378, 387 are simultaneously controlled into a closed (low impedance) state. In this reduced-power state, only inductive element 336 functions to resonate out some of drain-source capacitance 333 (inductive element 337 is bypassed), and inductive element 376 functions to resonate out some of drain-source capacitance 373 (inductive element 377 is bypassed). Additionally, inductive element 386 is bypassed, and therefore inductive element 386 does not affect the characteristic impedance of the reconfigurable output impedance transformer circuit 382.

As indicated above, at any given time, Doherty power amplifier 300 may be configured or reconfigured into a full-power state or into a reduced-power state. As discussed previously in conjunction with FIGs 1 and 2, the instantaneous configuration of Doherty power amplifier 300 may be controlled by the amplifier controller 114 based on control signals 104 from a base station controller 103 (FIG. 1).

According to an embodiment, the amplifier controller 114 includes memory (not shown) configured to store a lookup table that correlates the control signals 104 from the base station controller 103 with switch states for the plurality of switching elements 338, 353, 353, 378, 387 within the Doherty power amplifier 300.

To illustrate, below is a first example of a lookup table (Table 1) that may be utilized in conjunction with a reconfigurable Doherty power amplifier 300. The below lookup table includes entries for two amplifier states (i.e., *N =* 2, corresponding to a full-power state and a single reduced-power state).

**Table 1 - Switch states for amplifier 300**

| AMPLIFIER STATE | SWITCH STATE FOR SWITCHES 338, 378, 387 | SWITCH STATE FOR SWITCHES 352, 353 |
|---|---|---|
| FULL POWER (STATE 1) | OPEN | CLOSED |
| REDUCED POWER (STATE 2) | CLOSED | OPEN |

As Table 1 indicates, when the amplifier controller 114 receives a control signal 104 from the base station controller 103 that indicates that the amplifier 300 should be configured (or reconfigured) into a full-power state (FIG. 3, state 1), the amplifier controller 114 will provide switch control signals over switch control lines 116 that:
- cause switching elements 338, 378, 387 to be in an open state (i.e., all of inductive elements 336 + 337, 376 + 377 affect the effective output capacitance of amplifiers 331, 371, and circuit 389 establishes a relatively low impedance at combining node 380); and
- cause switching elements 352, 353 to be in a closed state (i.e., circuits 356, 356' and 359, 359' are coupled to the reconfigurable quasi-line).

Alternatively, when the amplifier controller 114 receives a control signal 104 from the base station controller 103 that indicates that the amplifier 300 should be configured (or reconfigured) into a reduced-power state (FIG. 4, state 2), the amplifier controller 114 will provide switch control signals over switch control lines 116 that:
- cause switching elements 338, 378, 387 to be in a closed state (i.e., only inductive elements 336, 376 affect the effective output capacitance of amplifiers 331, 371, and circuit 389 establishes a relatively high impedance at combining node 380); and
- cause switching elements 352, 353 to be in an open state (i.e., circuits 356, 356' and 359, 359' are uncoupled from the reconfigurable quasi-line).

For Doherty power amplifier 300, the above-described configurations provide correct phase relationships for optimal load modulation, and ensure that the amplified signals from the carrier and peaking paths 330, 370 arrive in phase (or coherently) at the combining node 380. Combining node 380 includes a conductive structure that is suitable for combining the amplified RF signals produced by the carrier and peaking amplification paths 330, 370 in order to produce an amplified combined output RF signal.

According to one or more embodiments, effective control of the reconfigurable Doherty power amplifier 300 to transition from a full-power state to a reduced-power state that is about 3 dB below the full-power state includes simultaneously:
- reconfiguring the variable output impedance transformer 382 to increase (e.g., double) the combining node impedance;
- reconfiguring the carrier and peaking output capacitance circuits 334, 374 to decrease (e.g., halve) the effective capacitances, *C_{EFF}*, at the outputs 332, 372 of the power amplifiers 331, 371; and
- reconfiguring the reconfigurable impedance inverter circuit 340 to increase (e.g., double) the total inductance, *L*_{TOT}, of the reconfigurable impedance inverter circuit 340.

Conversely, effective control of the reconfigurable Doherty power amplifier 300 to transition from a reduced-power state to a full-power state that is about 3 dB above the reduced-power state includes simultaneously:
- reconfiguring the variable output impedance transformer 382 to decrease (e.g., halve) the combining node impedance;
- reconfiguring the carrier and peaking output capacitance circuits 334, 374 to increase (e.g., double) the effective capacitances, *C_{EFF}*, at the outputs 332, 372 of the power amplifiers 331, 371; and
- reconfiguring the reconfigurable impedance inverter circuit 340 to decrease (e.g., halve) the total inductance, *L*_{TOT}, of the reconfigurable impedance inverter circuit 340.
Interestingly, for Doherty power amplifier 300, the values of *C_{EFF}* and *L*_{TOT} are controlled in an inverse manner (i.e., as *C_{EFF}* is decreased, *L*_{TOT} is increased, and vice versa).

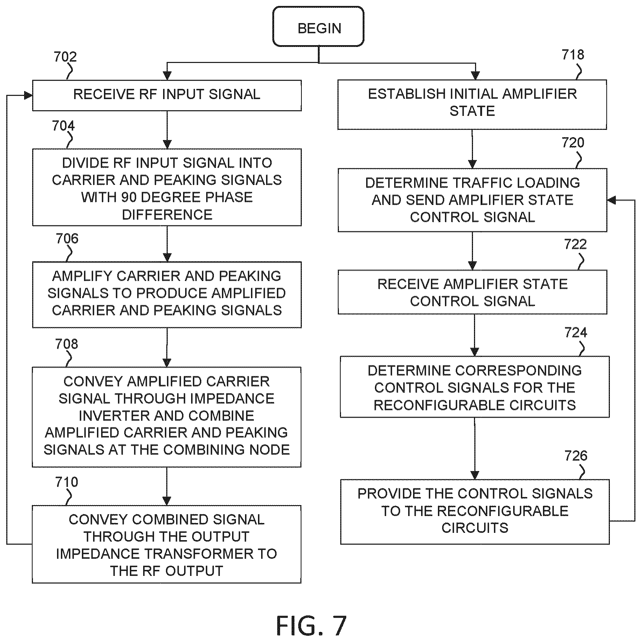

FIG. 7 is a flowchart of a method of operating a reconfigurable Doherty power amplifier (e.g., amplifier 300, FIGs 3,4), in accordance with an example embodiment. According to one or more embodiments, the method includes two parallel processes, including the processes performed by the Doherty power amplifier (e.g., amplifiers 112, 300, FIGs 1, 3, 4) and the processes performed by the base station controller and the amplifier controller (e.g., controllers 103, 114, FIGs 1, 3, 4). These parallel processes may be performed simultaneously (e.g., the RF signal is continuously amplified while reconfigurations of the variable networks are performed). Alternatively, reconfiguration of the variable networks could be performed while amplification of the RF signal is not occurring (e.g., prior to amplification or during a pause in amplification).

The processes performed by the Doherty power amplifier (e.g., amplifiers 112, 300, FIGs 1, 3, 4) will be summarized first. According to one or more embodiments, the method starts at block 702, which includes receiving (e.g., at RF input 108 and power splitter input 322) an input RF signal. For example, the input RF signal may be characterized by a fundamental frequency of operation, *f₀*. In block 704, the input RF signal is divided (e.g., by power splitter 320) into a carrier input RF signal and a peaking input RF signal. The carrier input RF signal is provided (e.g., through splitter output 324) to the input of the carrier amplifier (e.g., amplifier 331), and the peaking RF signal is provided (e.g., through splitter output 326) to the input of the peaking amplifier 371. One or more phase delays may be applied so that the carrier and peaking input RF signals are about 90 degrees out of phase with respect to each other at the carrier and peaking amplifier inputs. In block 706, the carrier input RF signal is amplified through the carrier amplifier (e.g., amplifier 331), and the peaking input RF signal is amplified through the peaking amplifier (e.g., amplifier 371).

According to one or more embodiments, in block 708, the amplified carrier RF signal is conveyed through the reconfigurable impedance inverter circuit (e.g., through circuit 340, 340', 340", FIGs 3-6) to the combining node (e.g., combining node 380). Simultaneously, the amplified peaking RF signal is conveyed to the combining node (e.g., combining node 380), and the amplified carrier and peaking RF signals are combined at the combining node 380. Finally, in block 710, and according to one or more embodiments, the amplified combined RF output signal is conveyed from the combining node through the reconfigurable output impedance transformer (e.g., reconfigurable output impedance transformer 382) to the RF output (e.g., RF output 110).

Simultaneously with the above-described amplification process performed by the Doherty power amplifier, various traffic loading assessment and amplifier control processes are performed in order to reconfigure the Doherty power amplifier into either a full-power state or a reduced-power state. According to one or more embodiments, prior to reconfiguring the Doherty power amplifier, an initial amplifier configuration is established in block 718. The initial amplifier configuration may be predetermined, in some embodiments, to correspond to any amplifier state (e.g., to the full-power state or to the reduced-power state). Establishing the initial amplifier configuration may involve the base station controller sending an amplifier state control signal to the Doherty power amplifier (or more specifically to an amplifier controller, such as controller 114, FIGs 1, 3, 4), and in response, the Doherty power amplifier determining and providing switch control signals for the reconfigurable output circuit (e.g., circuit 390, FIGs 3, 4) that correspond with the initial amplifier state. According to one or more embodiments, in order to provide the switch control signals, the amplifier controller (e.g., controller 114) may include multiple drivers (not shown), where each driver is coupled through the switch control lines 116 to one or more of the control terminals of the switching elements (e.g., switching elements 338, 352, 353, 378, 387, FIGs 3-6).

After establishing the initial amplifier state, the measurement and control processes include block 720, in which the base station controller (or another subsystem) determines the current traffic loading condition for the communication system. As discussed previously, the traffic loading can be determined based on measurements or determinations of the instantaneous traffic loading of the system, which are compared to one or more thresholds. Alternatively, the traffic loading can be estimated based on temporal factors (e.g., time-of-day, day-of week, etc.). Either way, the base station controller may determine, based on the measured or expected current traffic loading, a desired amplifier state (e.g., full power or reduced power). Upon determining the desired amplifier state, the base station controller generates and sends an amplifier state control signal to the Doherty power amplifier (or more specifically to an amplifier controller, such as controller 114). The amplifier state control signal may indicate at least one of the traffic loading condition, the power level (e.g., full power, reduced power), or an amplifier state (e.g., state 1, state 2).

According to one or more embodiments, in block 722, the amplifier controller (e.g., amplifier controller 114) receives the amplifier state control signal from the base station controller. In block 724, the amplifier controller then determines control signals for the reconfigurable output circuit (e.g., circuit 390, FIGs 3,4) that correspond with the desired amplifier state. As discussed previously, each reconfigurable output circuit may include a combining node (e.g., combining node 380, FIGs 3, 4), a reconfigurable impedance inverter circuit (e.g., circuit 340, 340', 340", FIGs 3-6), a reconfigurable carrier output capacitance circuit (e.g., circuit 334, FIGs 3, 4), a reconfigurable peaking output capacitance circuit (e.g., circuit 374, FIGs 3, 4), and a reconfigurable output impedance transformer (e.g., transformer 382, FIGs 3, 4) coupled between the combining node and the amplifier output terminal (e.g., RF output 110, FIGs 3, 4). The control signals produced by the amplifier controller may include control signals that cause the reconfigurable circuits (e.g., circuits 334, 340, 340', 340", 374, 382) to be reconfigured in order to achieve the desired amplifier state. For example, the control signals may include switch control signals (e.g., for changing the states of switching elements 338, 352, 353, 378, 387). The amplifier controller may determine the specific control signals, for example, using one or more lookup tables that correlate values for the control signals with switch states (for the switching elements 338, 352, 353, 378, 387). Other suitable control circuits alternatively may be utilized. Once the control signals are determined, then in block 726, the amplifier controller provides the control signals to the reconfigurable circuits (e.g., circuits 334, 340, 340', 340", 374, 382). According to one or more embodiments, the reconfigurable circuits are reconfigured in a synchronous manner with each other to establish each amplifier state. The amplification and network control processes are continuously repeated throughout operation of the Doherty power amplifier.

An embodiment of a Doherty power amplifier includes a first amplifier with a first amplifier output, a second amplifier with a second amplifier output, a combining node, and a reconfigurable impedance inverter circuit coupled between the first amplifier output and the combining node. The first amplifier is configured to produce an amplified first output signal, and the second amplifier is configured to produce an amplified second output signal. The combining node is configured to combine the amplified first output signal with the amplified second output signal. The reconfigurable impedance inverter circuit includes a first node coupled to the first amplifier output, a second node coupled to the second amplifier output, a first inductive element with a first terminal coupled to the first node and a second terminal coupled to the second node, and a switching circuit with a first switching circuit terminal coupled to the first node and a second switching circuit terminal coupled to the second node. The switching circuit is configured to be controlled into a first state and into a second state. The reconfigurable impedance inverter circuit also includes a fundamental frequency tuning circuit coupled between the switching circuit and a ground reference node, and a harmonic frequency resonance circuit coupled between the switching circuit and the ground reference node. The fundamental frequency tuning circuit is configured to resonate at or near a fundamental frequency of operation, and the harmonic frequency resonance circuit is configured to resonate at or near a second harmonic frequency of the fundamental frequency of operation. When the switching circuit is configured in the first state, the fundamental frequency tuning circuit and the harmonic frequency resonance circuit are electrically coupled through the switching circuit to the first and second nodes, and when the switching circuit is configured in the second state, the fundamental frequency tuning circuit and the harmonic frequency resonance circuit are electrically disconnected from the first and second nodes.

According to a further embodiment, the reconfigurable impedance inverter circuit also includes a first transmission line segment coupled between the first amplifier output and the first node, a second transmission line segment coupled between the second amplifier output and the second node, a third transmission line segment coupled between the first node and the first terminal of the switching circuit, and a fourth transmission line segment coupled between the second node and the second terminal of the switching circuit. The first transmission line segment is characterized by a first electrical length and a first characteristic impedance. The second transmission line segment is characterized by a second electrical length and a second characteristic impedance. The third transmission line segment is characterized by a third electrical length and a third characteristic impedance. The fourth transmission line segment is characterized by a fourth electrical length and a fourth characteristic impedance.

According to another further embodiment, the Doherty power amplifier also includes an amplifier controller coupled to the switching circuit. The amplifier controller is configured to receive a signal indicative of a full power state, and in response, to provide first control signals to the switching circuit to establish the switching circuit into the first state. In addition, the amplifier controller is configured to receive a signal indicative of a reduced power state, and in response, to provide second control signals to the switching circuit to establish the switching circuit into the second state.

According to yet another further embodiment, the first amplifier output is characterized by a first amplifier output capacitance, the second amplifier output is characterized by a second amplifier output capacitance, and the combining node is characterized by a combining node impedance. Additionally, the Doherty power amplifier further includes a reconfigurable carrier output capacitance circuit coupled to the first amplifier output, a reconfigurable peaking output capacitance circuit coupled to the second amplifier output and to the combining node, and an output impedance transformer coupled between the combining node and an output of the Doherty power amplifier. The reconfigurable carrier output capacitance circuit and the first amplifier output capacitance establish a first amplifier effective output capacitance that is less than the first amplifier output capacitance. The reconfigurable peaking output capacitance circuit and the second amplifier output capacitance establish a second amplifier effective output capacitance that is less than the second amplifier output capacitance. The output impedance transformer is configured to establish the combining node impedance.

An embodiment of a method of operating a Doherty power amplifier includes producing, by a first amplifier, an amplified first output signal at a first amplifier output, producing, by a second amplifier, an amplified second output signal at a second amplifier output, and conveying the amplified first output signal to a combining node through a reconfigurable impedance inverter circuit coupled between the first amplifier output and the combining node. The reconfigurable impedance inverter circuit includes a first node coupled to the first amplifier output, a second node coupled to the second amplifier output, a first inductive element with a first terminal coupled to the first node and a second terminal coupled to the second node, and a switching circuit with a first switching circuit terminal coupled to the first node and a second switching circuit terminal coupled to the second node. The switching circuit is configured to be controlled into a first state and into a second state. The reconfigurable impedance inverter circuit also includes a fundamental frequency tuning circuit coupled between the switching circuit and a ground reference node, and a harmonic frequency resonance circuit coupled between the switching circuit and the ground reference node. The fundamental frequency tuning circuit is configured to resonate at or near a fundamental frequency of operation. The harmonic frequency resonance circuit is configured to resonate at or near a second harmonic frequency of the fundamental frequency of operation. When the switching circuit is configured in the first state, the fundamental frequency tuning circuit and the harmonic frequency resonance circuit are electrically coupled through the switching circuit to the first and second nodes, and when the switching circuit is configured in the second state, the fundamental frequency tuning circuit and the harmonic frequency resonance circuit are electrically disconnected from the first and second nodes. The method further includes conveying the amplified second output signal to the combining node, combining the first and second amplified output signals at the combining node to produce an amplified combined output signal, and conveying the amplified combined output signal through an output impedance transformer coupled between the combining node and an output of the Doherty power amplifier.

According to a further embodiment, the method also includes configuring the switching circuit in the first state, in which the fundamental frequency tuning circuit and the harmonic frequency resonance circuit are electrically coupled through the switching circuit to the first and second nodes.

According to another further embodiment, the method also includes configuring the switching circuit in the second state, in which the fundamental frequency tuning circuit and the harmonic frequency resonance circuit are electrically disconnected from the first and second nodes.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or detailed description.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A Doherty power amplifier comprising:
a first amplifier with a first amplifier output, wherein the first amplifier is configured to produce an amplified first output signal;
a second amplifier with a second amplifier output, wherein the second amplifier is configured to produce an amplified second output signal;
a combining node configured to combine the amplified first output signal with the amplified second output signal;
a reconfigurable impedance inverter circuit coupled between the first amplifier output and the combining node, wherein the reconfigurable impedance inverter circuit includes
a first node coupled to the first amplifier output,
a second node coupled to the second amplifier output,
a first inductive element with a first terminal coupled to the first node and a second terminal coupled to the second node,
a switching circuit with a first switching circuit terminal coupled to the first node and a second switching circuit terminal coupled to the second node, wherein the switching circuit is configured to be controlled into a first state and into a second state,
a fundamental frequency tuning circuit coupled between the switching circuit and a ground reference node, wherein the fundamental frequency tuning circuit is configured to resonate at or near a fundamental frequency of operation,
a harmonic frequency resonance circuit coupled between the switching circuit and the ground reference node, wherein the harmonic frequency resonance circuit is configured to resonate at or near a second harmonic frequency of the fundamental frequency of operation, and
wherein, when the switching circuit is configured in the first state, the fundamental frequency tuning circuit and the harmonic frequency resonance circuit are electrically coupled through the switching circuit to the first and second nodes, and when the switching circuit is configured in the second state, the fundamental frequency tuning circuit and the harmonic frequency resonance circuit are electrically disconnected from the first and second nodes.

2. The Doherty power amplifier of claim 1, wherein the reconfigurable impedance inverter circuit further comprises:
a second inductive element coupled between the first node and the ground reference node.

3. The Doherty power amplifier of claim 1 or 2, wherein:
the harmonic frequency resonance circuit is primarily **characterized by** a capacitance at the fundamental frequency of operation, and
the fundamental frequency tuning circuit is primarily **characterized by** an inductance at the fundamental frequency of operation, and
when the switching circuit is configured in the first state, the inductance of the fundamental frequency tuning circuit counteracts the capacitance of the harmonic frequency resonance circuit.

4. The Doherty power amplifier of any preceding claim, wherein the reconfigurable impedance inverter circuit further comprises:
a first transmission line segment coupled between the first amplifier output and the first node, wherein the first transmission line segment is **characterized by** a first electrical length and a first characteristic impedance;
a second transmission line segment coupled between the second amplifier output and the second node, wherein the second transmission line segment is **characterized by** a second electrical length and a second characteristic impedance;
a third transmission line segment coupled between the first node and the first terminal of the switching circuit, wherein the third transmission line segment is **characterized by** a third electrical length and a third characteristic impedance; and
a fourth transmission line segment coupled between the second node and the second terminal of the switching circuit, wherein the fourth transmission line segment is **characterized by** a fourth electrical length and a fourth characteristic impedance.

5. The Doherty power amplifier of any preceding claim, wherein:
the fundamental frequency tuning circuit includes a second inductive element and a first capacitor coupled in series between the switching circuit and the ground reference node; and
the harmonic frequency resonance circuit includes a third inductive element and a second capacitor coupled in series between the switching circuit and the ground reference node.

6. The Doherty power amplifier of any preceding claim, wherein:
the fundamental frequency tuning circuit includes a first shunt stub; and
the harmonic frequency resonance circuit includes a second shunt stub.

7. The Doherty power amplifier of any preceding claim, further comprising:
a first DC blocking capacitor coupled between the first amplifier output and the first node; and
a second DC blocking capacitor coupled between the second amplifier output and the second node.

8. The Doherty power amplifier of any preceding claim, further comprising:
an amplifier controller coupled to the switching circuit, wherein
the amplifier controller is configured to receive a signal indicative of a full-power state, and in response, to provide first control signals to the switching circuit to establish the switching circuit into the first state, and
the amplifier controller is configured to receive a signal indicative of a reduced-power state, and in response, to provide second control signals to the switching circuit to establish the switching circuit into the second state.

9. The Doherty power amplifier of claim 8, wherein the switching circuit comprises:
a first switching element coupled between the first switching circuit terminal and an intermediate node; and
a second switching element coupled between the intermediate node and the second switching circuit terminal, and
wherein the fundamental frequency tuning circuit and the harmonic frequency resonance circuit both are coupled between the intermediate node and the ground reference node,
when the switching circuit is configured in the first state, the first and second switching elements are configured in a closed state, and
when the switching circuit is configured in the second state, the first and second switching elements are configured in an open state.

10. The Doherty power amplifier of claim 8 or 9, wherein the switching circuit comprises:
a first switching element coupled between the first switching circuit terminal and an intermediate node; and
a second switching element coupled between the intermediate node and the second switching circuit terminal, and
wherein the fundamental frequency tuning circuit is coupled between the intermediate node and the ground reference node,
the harmonic frequency resonance circuit is coupled between the second switching circuit terminal and the ground reference node,
when the switching circuit is configured in the first state, the first and second switching elements are configured in a closed state, and
when the switching circuit is configured in the second state, the first and second switching elements are configured in an open state.

11. The Doherty power amplifier of any preceding claim, wherein:
the first amplifier output is **characterized by** a first amplifier output capacitance;
the second amplifier output is **characterized by** a second amplifier output capacitance;
the combining node is **characterized by** a combining node impedance; and
wherein the Doherty power amplifier further includes
a reconfigurable carrier output capacitance circuit coupled to the first amplifier output, wherein the reconfigurable carrier output capacitance circuit and the first amplifier output capacitance establish a first amplifier effective output capacitance that is less than the first amplifier output capacitance,
a reconfigurable peaking output capacitance circuit coupled to the second amplifier output and to the combining node, wherein the reconfigurable peaking output capacitance circuit and the second amplifier output capacitance establish a second amplifier effective output capacitance that is less than the second amplifier output capacitance, and
an output impedance transformer coupled between the combining node and an output of the Doherty power amplifier, wherein the output impedance transformer is configured to establish the combining node impedance.

12. The Doherty power amplifier of claim 11, wherein:
the reconfigurable carrier output capacitance circuit includes a first bypass switch with a first terminal and a second terminal, a first capacitor and a second inductive element coupled in series between the first amplifier output and the first terminal of the first bypass switch, and a third inductive element coupled between the first terminal of the first bypass switch and the ground reference node, wherein the second terminal of the first bypass switch is coupled to the ground reference node;
the reconfigurable peaking output capacitance circuit includes a second bypass switch with a first terminal and a second terminal, a second capacitor and a fourth inductive element coupled in series between the second amplifier output and the first terminal of the second bypass switch, and a fifth inductive element coupled between the first terminal of the second bypass switch and the ground reference node, wherein the second terminal of the second bypass switch is coupled to the ground reference node; and
the output impedance transformer includes a transmission line segment with a first end coupled to the combining node and a second end coupled to an output terminal of the Doherty power amplifier, a third capacitor coupled between the first end and the ground reference node, and a reconfigurable inductor-capacitor circuit coupled between the second end and the ground reference node, wherein the reconfigurable inductor-capacitor circuit includes a third bypass switch with a first terminal and a second terminal, a fourth capacitor coupled between the second end and the first terminal of the third bypass switch, and a sixth inductive element coupled between the first terminal of the third bypass switch and the ground reference node, wherein the second terminal of the third bypass switch is coupled to the ground reference node,
when the switching circuit is configured in the first state, the first, second, and third bypass switches are configured in an open state, and
when the switching circuit is configured in the second state, the first, second, and third bypass switches are configured in a closed state.

13. The Doherty power amplifier of claim 11 or 12, wherein
the first amplifier includes a first power transistor with a first drain terminal and a first source terminal, wherein the first drain terminal corresponds to the first amplifier output;
the first amplifier output capacitance is a first drain-source capacitance between the first drain terminal and the first source terminal;
the second amplifier includes a second power transistor with a second drain terminal and a second source terminal, wherein the second drain terminal corresponds to the second amplifier output; and
the second amplifier output capacitance is a second drain-source capacitance between the second drain terminal and the second source terminal.

14. A method of operating a Doherty power amplifier, the method comprising:
producing, by a first amplifier, an amplified first output signal at a first amplifier output;
producing, by a second amplifier, an amplified second output signal at a second amplifier output;
conveying the amplified first output signal to a combining node through a reconfigurable impedance inverter circuit coupled between the first amplifier output and the combining node, wherein the reconfigurable impedance inverter circuit includes
a first node coupled to the first amplifier output,
a second node coupled to the second amplifier output,
a first inductive element with a first terminal coupled to the first node and a second terminal coupled to the second node,
a switching circuit with a first switching circuit terminal coupled to the first node and a second switching circuit terminal coupled to the second node, wherein the switching circuit is configured to be controlled into a first state and into a second state,
a fundamental frequency tuning circuit coupled between the switching circuit and a ground reference node, wherein the fundamental frequency tuning circuit is configured to resonate at or near a fundamental frequency of operation,
a harmonic frequency resonance circuit coupled between the switching circuit and the ground reference node, wherein the harmonic frequency resonance circuit is configured to resonate at or near a second harmonic frequency of the fundamental frequency of operation, and
wherein, when the switching circuit is configured in the first state, the fundamental frequency tuning circuit and the harmonic frequency resonance circuit are electrically coupled through the switching circuit to the first and second nodes, and when the switching circuit is configured in the second state, the fundamental frequency tuning circuit and the harmonic frequency resonance circuit are electrically disconnected from the first and second nodes;
conveying the amplified second output signal to the combining node;
combining the first and second amplified output signals at the combining node to produce an amplified combined output signal; and
conveying the amplified combined output signal through an output impedance transformer coupled between the combining node and an output of the Doherty power amplifier.

15. The method of claim 14, further comprising at least one of:
configuring the switching circuit into the first state, in which the fundamental frequency tuning circuit and the harmonic frequency resonance circuit are electrically coupled through the switching circuit to the first and second nodes; and .
configuring the switching circuit into the second state, in which the fundamental frequency tuning circuit and the harmonic frequency resonance circuit are electrically disconnected from the first and second nodes.
